# DEMANDE DE BREVET EUROPEEN

(11) **EP 1 073 072 A1**
(43) Date de publication de la demande: **31.01.2001**
(21) Numéro de dépôt: 00401938.6
(22) Date de dépôt: 06.07.2000
(51) Int. Cl.: H01F 17/00, H01F 41/04, H05K 1/16

(54) **Procédé pour l'obtention d'un module incluant un bobinage inductif et module correspondant.**

(30) Priorité: 29.07.1999 FR 9909860
(71) Demandeur: ALCATEL, 75008 Paris (FR)
(72) Inventeur: Venet, Norbert, 31880 La Salvetat St. Gilles (FR); Drevon, Claude, 31500 Toulouse (FR); Albinet, Stéphane, 31830 Plaisance du Touch (FR)
(74) Mandataire: Smith, Bradford Lee

(57) **Abrégé**

Procédé pour l'obtention d'un module comportant au moins un bobinage constitué de pistes conductrices réalisées sur circuit imprimé et module (1) obtenu. le procédé implique
- un empilage d'éléments modulaires de film de circuit imprimé (3A, 3N) ;
- un moulage de l'ensemble formé par l'empilage d'éléments modulaires en un bloc rigide ;
- au moins une opération de découpe du bloc moulé, latéralement au long de l'empilage, pour mettre à nu des pistes conductrices qui se terminent à un même niveau d'alignement et les faire affleurer en surface du bloc au niveau d'une face ;
- une opération de création de connexions sur la ou les faces du bloc où affleurent des pistes conductrices d'éléments modulaires pour une interconnexion sélective de ces dernières et pour leur raccordement à des moyens de connexion externes au module.

## Description

L'invention concerne un procédé destiné à permettre d'obtenir un module monobloc incluant un bobinage inductif. Elle concerne aussi les modules monoblocs électroniques et notamment les modules à bobinage entourant un noyau magnétique obtenus par mise en oeuvre de ce procédé tels que par exemple des modules de type convertisseur.

Il est connu de réaliser des bobinages composés de spires superposées qui sont constituées par des pistes conductrices portées par un circuit imprimé replié sur lui-même pour permettre l'alignement des spires au long d'un axe correspondant à l'axe du bobinage à réaliser.

Le document US-A-5801611 décrit un dispositif inductif obtenu de cette manière à l'aide d'un circuit imprimé sur les deux faces duquel des spires de bobinage sont réalisées en des emplacements du circuit qui sont placés l'un au-dessus de l'autre, dans des plans parallèles, par repliement multiple du circuit sur lui-même. Il est nécessaire de prévoir des connexions traversant le circuit imprimé pour permettre de relier l'extrémité intérieure de l'ensemble spiralé que constitue les spires en un emplacement du circuit imprimé avec une extrémité correspondante de l'ensemble spiralé suivant du bobinage à réaliser. Ces connexions sont classiquement réalisées sous la forme de trous métallisés qui traversent le circuit imprimé pour relier chacun des deux ensembles spiralés. Des solutions de ce genre sont relativement coûteuses et assez délicates à réaliser, de plus elles présentent une fiabilité qui n'est pas toujours satisfaisante.

L'invention propose donc un procédé prévu pour permettre d'obtenir, dans de bonnes conditions, un module comportant au moins un bobinage inductif, constitué d'une ou de plusieurs pistes conductrices réalisées sur un support de type film de circuit imprimé où ces pistes forment des spires qui sont combinées pour former un bobinage ou plusieurs bobinages parallèles et/ou coaxiaux.

Selon une caractéristique de l'invention, ce procédé prévoit les opérations suivantes :
- la réalisation d'un empilage composé d'une pluralité d'éléments modulaires de film de circuit imprimé, alignés et portant un ensemble de spires qui sont destinées à faire partie d'un ou de plusieurs bobinages, parallèles et/ou coaxiaux, et dont les pistes se terminent au niveau ou à proximité d'un bord de l'élément qui les comporte ;
- le moulage de l'ensemble formé par l'empilage d'éléments modulaires, dans un matériau isolant permettant de constituer un bloc rigide ;
- au moins une opération de découpe du bloc moulé, latéralement au long de l'empilage, pour mettre à nu les pistes conductrices à un même niveau d'alignement et les faire affleurer en surface du bloc, au niveau d'une face ;
- une opération de création de connexions sur la ou les faces du bloc où affleurent des pistes conductrices d'éléments modulaires pour une interconnexion sélective de ces dernières et pour leur raccordement à des moyens de connexion externes au module.

Selon l'invention, il est aussi prévu d'associer, à au moins une des extrémités d'un empilage d'éléments modulaires, un ou des éléments modulaires de circuit imprimé supplémentaires qui sont porteurs de composants et qui ont des pistes conductrices se terminant à un niveau correspondant à un niveau d'alignement d'éléments modulaires de l'empilage, pour simultanément réaliser les opérations de moulage, de découpe et de connexion à l'ensemble des éléments modulaires ainsi associés. Une telle association dans le cadre du procédé selon l'invention permet de constituer un module fonctionnel électronique complet par empilage d'éléments modulaires et d'effectuer le raccordement entre tous les éléments modulaires par une opération de connexion, commune à tous ces éléments.

Selon l'invention, il est aussi prévu de ménager au moins un orifice en même position dans des éléments modulaires, destinés à constituer un module, pour permettre d'y former un conduit permettant l'insertion d'un noyau, au travers des éléments modulaires ainsi agencés. Une telle disposition permet notamment de réaliser, avec un minimum d'opérations, des blocs convertisseurs comportant des bobinages alignés au long de noyaux magnétiques.
L'invention propose aussi un module électronique, réalisé sous la forme d'un bloc qui comporte au moins un bobinage inductif constitué d'une ou de plusieurs pistes conductrices réalisées sur un support de type film de circuit imprimé où ces pistes forment des spires qui sont combinées pour former le bobinage ou des bobinages parallèles et/ou coaxiaux.

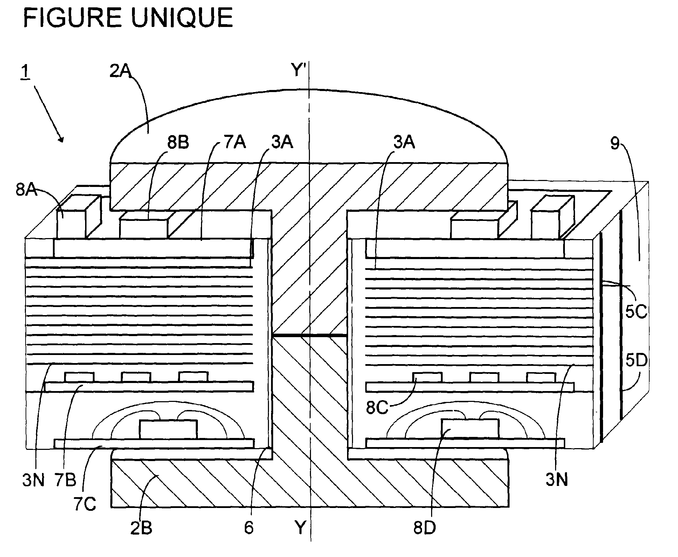

Selon une caractéristique de l'invention, ce module comporte un empilage d'éléments modulaires de film de circuit imprimé. Ces éléments sont identiquement alignés et portent chacun une ou des spires qui sont destinées à faire partie d'un ou de plusieurs bobinages parallèles et/ou coaxiaux. Les pistes constituant ces spires se terminent au niveau d'un face, déterminée par des bords alignés d'éléments modulaires empilés, sur laquelle des pistes conductrices d'interconnexion entre spires sont réalisées. Le module obtenu présente l'avantage de constituer un bloc rigide, par exemple cubique ou parallélépipédique rectangle, comportant un réseau de connexion au niveau d'au moins une face.
Selon une variante de l'invention, le module est un module électronique à noyau magnétique, réalisé sous la forme d'un bloc qui comporte au moins un bobinage constitué de pistes conductrices réalisées sur un support de type film de circuit imprimé de manière à former des spires de bobinage, selon une disposition déterminée. Ce module comporte plus particulièrement un empilage d'éléments modulaires de film de circuit imprimé qui sont alignés et qui portent chacun une ou des spires destinées à faire partie d'un ou de plusieurs bobinages parallèles et/ou coaxiaux. Les pistes constituant ces spires se terminent au niveau d'une face, déterminée par des bords alignés d'éléments modulaires empilés. Cette face porte de pistes conductrices d'interconnexion entre spires et des éléments de raccordement à des moyens de connexion externes. Au moins certains des modules dits ajourés, qui sont adjacents dans l'empilage comportent identiquement une ouverture ménagée au centre d'au moins une spire relative à un bobinage déterminée pour permettre le passage d'un noyau se logeant dans le conduit formé par des modules successifs ainsi ajourés.
Selon une variante de l'invention, le module, qui peut notamment être un module convertisseur, comporte au moins un élément modulaire de circuit imprimé supplémentaire, porteur de composants, qui est noyé dans le bloc moulé à au moins une des extrémités de l'empilage d'éléments formant un ou des bobinages. Chaque élément supplémentaire comporte des pistes conductrices se terminant et se raccordant électriquement au niveau de pistes conductrices réalisées sur une face déterminée par des bords alignés d'éléments modulaires empilés, au niveau du bloc. L'invention, ses caractéristiques et ses avantages sont précisés dans la description qui suit en liaison avec la figure unique évoquée ci-dessous.
Cette figure unique présente une coupe d'un module électronique, selon l'invention qui comporte un bobinage inductif constitué à partir de pistes conductrices formant des spires qui entourent un noyau magnétique.
Le procédé selon l'invention est destiné à permettre l'obtention de modules comportant un ou plusieurs bobinages composés chacun d'une pluralité de spires dont l'élément conducteur est constitué par une piste conductrice portée par un circuit imprimé de faible épaisseur, et par exemple d'un circuit imprimé réalisé sur un film.
L'exemple de module électronique 1 schématisé sur la figure 1 est un module comportant un bobinage inductif réalisé autour d'un noyau magnétique, ici constitué en deux parties 2A, 2B mises bout à bout. Un tel agencement est par exemple destiné à constituer un convertisseur.
Un tel module est ici supposé comporter un ou plusieurs bobinages entourant la partie tubulaire médiane du noyau que constitue les deux parties 2A et 2B mises bout à bout. Ces bobinages peuvent préférablement avoir des axes parallèles et/ou coaxiaux suivant qu'ils ont des axes longitudinaux parallèles ou un axe commun et dans ce cas ils peuvent être concentriques ou alignés à la suite l'un de l'autre, suivant les besoins. Dans la suite de la description, pour des raisons de simplification, il n'est fait état que d'un bobinage qui est supposé réalisé de manière à s'aligner selon l'axe longitudinal YY' du module.
Les spires de bobinage du module sont constituées, de manière connue en soi, par des pistes conductrices portées par un film de circuit imprimé et elles déterminent des motifs répétitifs d'allure spiralée qui sont destinés à être empilés les uns sur les autres. Cet empilage est ici supposé réalisé selon l'axe longitudinal YY' pour le module représenté. Selon l'invention, les motifs répétitifs sont réalisés sur des éléments modulaires de film de circuit imprimé qui sont séparés l'un de l'autre et qui sont destinés à être empilés l'un sur l'autre, comme montré sur la figure unique pour les éléments de film 3A sur la figure unique. Dans l'exemple présenté, ces éléments de film, tels les éléments 3A et 3N, sont supposés d'allure rectangulaire et ils comportent une ouverture au travers duquel il est prévu de faire passer la partie tubulaire médiane du noyau constitué par les deux parties 2A, 2B mises bout à bout. Les spires comportées par les éléments de film sont supposées identiquement réalisées autour de l'ouverture centrale de l'élément qui les portent. Par contre les pistes conductrices qui les constituent sont supposées se prolonger jusqu'à la périphérie de l'élément de film porteur. Dans une forme préférée de réalisation, les éléments de film porteurs de spires qui sont destinés à faire partie d'un même empilage ont préférablement mêmes dimensions et les pistes conductrices formant les spires qu'ils comportent se reproduisent identiquement sur tous les éléments de film.
Ces éléments de film destinés à être empilés sont alignés dans un montage de positionnement. Cet alignement est par exemple assuré par l'intermédiaire de tiges fixes incluses dans le montage de positionnement sur lesquelles les éléments de film, porteurs de perforations en des positions prédéterminées, viennent s'enficher. Les pistes conductrices correspondant aux spires se prolongent par exemple jusqu'à un bord d'alignement ou éventuellement s'arrêtent à une même distance d'un tel bord d'élément. Il est également envisageable de faire aligner des pistes conductrices différentes sur des bords d'alignement différents en particulier sur des bords opposés des éléments, si besoin est.
Dans une forme préférée de mise en oeuvre du procédé d'obtention de module selon l'invention, les éléments modulaires, tels 3A, 3N, destinés à constituer un bobinage par empilage, sont empilés dans un montage de positionnement où ils se superposent exactement l'un sur l'autre en raison de leurs dimensions identiques et d'un guidage de positionnement qu'assure le montage. Les extrémités des pistes conductrices qui se correspondent sont alors alignées, , comme symbolisé par les droites 5C et 5D sur la figure unique. Ces alignements forment des rangées parallèles à l'axe d'empilage qui correspond en pratique à l'axe longitudinal YY' du module obtenu par la suite.
L'empilage réalisé est alors noyé dans un matériau isolant, usuellement de type résine polymère, qui est durci et qui donne naissance à un bloc, ici supposé de dimensions régulières par exemple parallélépipédique rectangle. Dans le cas d'un module comportant un noyau magnétique, le moulage laisse subsister un conduit 6 pour le logement du noyau, au travers des éléments modulaires de film de l'empilage.
Il est également prévu d'associer des éléments modulaires supplémentaires de circuit imprimé, tels que les éléments 7A, 7B, 7C, à au moins une extrémité d'un empilage, de manière à compléter fonctionnellement le module qui comporte le bobinage obtenu par empilage et à inclure le tout dans un même bloc de matériau isolant moulé. Les éléments modulaires supplémentaires de circuit imprimé peuvent être de type simple face, double face ou multicouches, ils permettent de monter des composants et par exemple des composants rapportés de type CMS. Ces composants peuvent être positionnés, soit à l'extérieur du bloc, tels les composants 8A, 8B, ou à l'intérieur de ce bloc, tels les composants 8C, 8D. Les éléments modulaires supplémentaires présentent la caractéristique d'avoir des pistes conductrices qui se prolongent jusqu'à un bord d'alignement de l'élément ou à une même distance d'un tel bord, de même que celles des éléments modulaires 3A, 3N empilés.
L'opération de moulage est alors réalisée sur l'ensemble des éléments modulaires, tels que 3A, 3N, 7A, 7B, 7C, disposés dans le montage de positionnement de manière que ces modules se trouvent perpendiculaires à un axe correspondant à l'axe longitudinal YY' du module, au long duquel les modules sont pré-positionnés.
Ce pré-positionnement est par exemple obtenu par utilisation d'un système à cales amovibles.
Après moulage, le bloc obtenu est soumis à une opération de découpe réalisée parallèlement à l'axe longitudinal du module, en vue de faire affleurer les pistes conductrices des éléments modulaires au niveau d'au moins une des faces latérales, telle 9, du bloc moulé du module obtenu.
Une opération de création de connexions est alors réalisée au niveau de la ou des faces de bloc où affleurent des pistes conductrices d'éléments modulaires de manière à relier ces dernières à des pistes d'interconnexion et/ou à des éléments de connexion pour des moyens de connexion externes au boîtier. Dans une forme préférée de réalisation, cette opération est réalisée par une métallisation d'au moins la ou les faces de bloc concernées. Des pistes conductrices d'interconnexion sélective entre éléments modulaires, telles 5C et 5D, et des éléments de connexion pour des moyens de connexion externes au boîtier sont ainsi ménagés sur la ou les faces métallisées. Ceci est par exemple obtenu par une métallisation localisée, ou par une métallisation suivie d'une élimination sélective du dépôt métallique ménageant plus particulièrement les pistes et les zones prévues pour les éléments de connexion, là où affleurent les pistes conductrices des éléments modulaires de circuit imprimé sur la ou les faces de bloc concernées Les éléments de connexion sont par exemple du type de ceux classiquement prévus pour des moyens de connexion externes par billes ou pistes conductrices, de type dit lead frame.
Une protection des pistes conductrices présentes sur les faces de bloc est éventuellement réalisée par dépôt d'une ou de plusieurs couches de matériau isolant, si besoin est et comme usuel en la matière.
Dans une forme particulière de réalisation, la finition du module est complétée par la mise en place du noyau, si l'accès au logement 6 de noyau prévu dans le bloc débouche à l'extérieur de ce bloc. Dans l'exemple illustré, les deux parties 2A, 2B du noyau sont alors mises en place de part et d'autre du module où leurs parties tubulaires respectives viennent se rejoindre et se fixer l'une à l'autre, par exemple par collage.

## Revendications

1. Procédé pour l'obtention d'un module (1) comportant au moins un bobinage inductif constitué d'une ou de plusieurs pistes conductrices réalisées sur un support de type film de circuit imprimé où ces pistes forment des spires qui sont combinées pour former un bobinage ou plusieurs bobinages parallèles et/ou coaxiaux, caractérisé en ce qu'il prévoit:
- un empilage d'une pluralité d'éléments modulaires de film de circuit (3A, 3N), alignés et portant un ensemble de spires qui sont destinées à faire partie d'un ou de plusieurs bobinages parallèles et/ou coaxiaux et dont les pistes se terminent au niveau ou à proximité du ou d'un bord de l'élément qui les comporte ;
- un moulage de l'ensemble formé par l'empilage d'éléments modulaires dans un matériau isolant permettant de constituer un bloc rigide ;
- au moins une opération de découpe du bloc moulé, latéralement au long de l'empilage, pour mettre à nu les pistes conductrices à un même niveau d'alignement et les faire affleurer en surface du bloc au niveau d'une face ;
- une opération de création de connexions sur la ou les faces du bloc où affleurent des pistes conductrices d'éléments modulaires pour une interconnexion sélective de ces dernières et pour leur raccordement à des moyens de connexion externes au module.

2. Procédé, selon la revendication 1, dans lequel il est prévu d'associer, à au moins une des extrémités d'un empilage d'éléments modulaires (3A, 3N), un ou des éléments modulaires de circuit imprimé supplémentaires (7A, 7B, 7C) qui sont porteurs de composants (8A, 8B, 8C) et qui ont des pistes conductrices se terminant à un niveau correspondant à un niveau d'alignement d'éléments modulaires de l'empilage, pour simultanément réaliser les opérations de moulage, de découpe et de création de connexions à l'ensemble des éléments modulaires ainsi associés.

3. Procédé, selon l'une des revendications 1, 2, dans lequel il est prévu de ménager au moins un orifice en même position dans des éléments modulaires destinés à constituer un module pour permettre d'y former un conduit (6) permettant l'insertion d'un noyau au travers des éléments modulaires ainsi agencés.

4. Module électronique, réalisé sous la forme d'un bloc qui comporte au moins un bobinage inductif constitué d'une ou de plusieurs pistes conductrices réalisées sur un support de type film de circuit imprimé où ces pistes forment des spires qui sont combinées pour former le bobinage ou des bobinages parallèles et/ou coaxiaux, caractérisé en ce qu'il comporte un empilage d'éléments modulaires de film de circuit imprimé alignés (3A, 3N) sur au moins un de leurs bords et portant chacun une ou des spires qui sont destinées à faire partie d'un ou de plusieurs bobinages parallèles et/ou coaxiaux et dont les pistes se terminent au niveau d'une face déterminée par des bords alignés d'éléments modulaires empilés au niveau de laquelle sont réalisées des pistes conductrices (5C, 5D) de connexion des spires entre elles.

5. Module électronique à noyau, réalisé sous la forme d'un bloc qui comporte au moins un bobinage constitué de pistes conductrices réalisées sur un support de type film de circuit imprimé de manière à former des spires, selon une disposition déterminée, et où au moins certaines des spires sont combinées pour former un bobinage, caractérisé en ce qu'il comporte un empilage d'éléments modulaires de film de circuit imprimé (3A, 3N) alignés sur au moins un de leurs bords et portant chacun une ou des spires qui sont destinées à faire partie d'un ou de plusieurs bobinages parallèles et/ou coaxiaux et dont les pistes se terminent au niveau d'une face, déterminée par des bords alignés d'éléments modulaires empilés, au niveau de laquelle sont réalisées des pistes conductrices de connexion (5C, 5D) pour les spires entre elles et des éléments de raccordement à des moyens de connexion externes, et en ce qu'au moins certains des modules dits ajourés, qui sont adjacents dans l'empilage comportent identiquement une ouverture ménagée au centre d'au moins une spire relative à un bobinage déterminée pour former un conduit permettant le passage d'un noyau se logeant dans le conduit formé par des modules successifs ainsi ajourés.

6. Module, notamment module convertisseur, selon l'une des revendications 4 ou 5, dans lequel au moins un élément modulaire de circuit imprimé supplémentaire (7A, 7B, 7C), porteur de composants, est noyé dans le bloc moulé à au moins une des extrémités de l'empilage d'éléments (3A, 3N) formant un ou des bobinages, chacun des éléments supplémentaires comportant des pistes conductrices se terminant et se raccordant électriquement au niveau de pistes conductrices (5C, 5D) réalisées sur une face déterminée par des bords alignés d'éléments modulaires empilés, au niveau du bloc.
